# EUROPEAN PATENT APPLICATION

(11) **EP 4 563 929 A1**
(43) Date of publication of application: **04.06.2025**
(21) Application number: 23213388.4
(22) Date of filing: 30.11.2023
(51) Int. Cl.: F28F 7/02, H05K 7/20

(54) **HEAT EXCHANGER**

(71) Applicant: Nexperia B.V., 6534 AB Nijmegen (NL); Nexperia Technology (Shanghai) Ltd., Shanghai 200025 (CN)
(72) Inventor: Ng, Siu Lung, Hong Kong (HK); Högerl, Jürgen, Munich (DE)
(74) Representative: Pjanovic, Ilija

(57) **Abstract**

There is disclosed a heat exchanger for a power module for an inverter system. The heat exchanger comprises a body that defines an inlet, an outlet. At least one enclosed channel is integrally formed within the body, the at least one enclosed channel being in fluid communication with the inlet and the outlet.

## Description

### Field of Invention

The present invention relates to a heat exchanger for a power module. The present invention also relates to a power module comprising the heat exchanger, and to a method of manufacturing a heat exchanger.

### Background

Power modules are commonly used in inverter systems. Power modules are used to convert the power supply from AC to DC, and to ensure that the power is supplied to a components, such as an electric motor, at the correct voltage and current.

Heat is generated by the power modules in use, which can lead to overheating. Overheating is undesirable as it can impair the function of the power module, and ultimately lead to failure of the power module. Heat is typically extracted by a suitable heat exchanger to reduce the likelihood of overheating. Conventional heat exchangers operate by supplying a fluid to the heat exchanger such that the heat generated by the power module passes to the fluid. Proper sealing of the heat exchanger is required to prevent moisture passing from the heat exchanger to the power module.

The present invention seeks to obviate, or at least mitigate, the problems associated with known apparatus, whether identified herein or otherwise.

### Summary

According to a first aspect of the invention there is provided a heat exchanger for a power module for an inverter system. The heat exchanger comprises a body that defines an inlet, an outlet. At least one enclosed channel is integrally formed within the body, the at least one enclosed channel being in fluid communication with the inlet and the outlet.

The at least one channel being enclosed may be understood to mean that the channel is closed to define a flow area of the channel, but the channel is able to receive a fluid from the inlet and the fluid is able to be discharged from the body via the outlet.

The body may comprise an inlet connector. The inlet connector may be disposed in the region of the inlet. An inlet fluid line may be connectable to the inlet connector. The body may comprise an outlet connector. The outlet connector may be disposed in the region of the outlet. An outlet fluid line may be connectable to the outlet connector.

Since the enclosed channels are integrally formed with the body, separate portions of the body are not required and so no seals are required between portions of the body. This is desirable because seals present a risk of leakage of the fluid that passes through the at least one channel. Leaked fluid can damage the power module due to, for example, corrosion. Therefore, enclosed channels being integrally formed with the body reduces the likelihood of leakage, resulting in a heat exchanger that is more robust than conventional heat exchangers.

The at least one channel may define a meandering path.

Where the channel defines a meandering path, the heat exchanger is able to extract more heat from the power module as compared to if the channel were to define, for example, a linear path. This is because the path length of the channel is increased by virtue of the meandering path. Therefore, where the at least one channel defines a meandering path, the heat exchanger is able to operate more efficiently.

A width of the at least one channel may be constant along a length of the at least one channel.

The width of the at least one channel may be constant along the entire length of the at least one channel.

Where the width of the at least one channel is constant, the heat exchanger is able to extract heat from the power module more efficiently. This is because the heat extraction is more uniform, as compared to if the width of the channels was not constant.

A plurality of enclosed channels, an inlet manifold and an outlet manifold may be formed within the body. Each of the channels of the plurality of channels may extend between the inlet manifold and the outlet manifold.

Where a plurality of channels that extend between an inlet manifold and an outlet manifold, the heat exchanger is able to extract more heat from the power module, as compared to if a single channel were provided. It will be appreciated that the temperature of the fluid increases as it travels through the heat exchanger. Where a plurality of channels that extend between an inlet manifold and an outlet manifold are provided, the distance that the fluid travels as it passes through the channels can be optimised. This allows for improved cooling of the power module in use.

Where a plurality of channels are provided, each channel may have any of the features disclosed with respect to the at least one channel.

The heat exchanger may further comprise an inlet conduit that is in direct sealing engagement with the inlet and an outlet conduit that is in direct sealing engagement with the outlet.

Throughout this document, the phrase 'direct sealing engagement' may be understood to mean that no separate sealing members are provided between the inlet conduit or the outlet conduit and the inlet or the outlet respectively. Put another way, the inlet conduit and the outlet conduit extend from the inlet and outlet of the body in a continuous manner.

The inlet conduit may comprise an inlet connector. An inlet fluid line may be connectable to the inlet connector. The outlet conduit may comprise an outlet connector. An outlet fluid line may be connectable to the outlet connector.

The inlet conduit and the outlet conduit may be brought into direct sealing engagement through any suitable process such as, for example, a welding process such as friction spin welding. Alternatively, the inlet conduit and outlet conduit may be integrally formed with the body.

In a second aspect of the invention there is provided a power module for an inverter system. The power module comprises a substrate, a heat exchanger according to the first aspect of the invention. A first major surface of the body of the heat exchanger being in contact with the substrate. The power module further comprises a cover that at least partially covers the substrate, and the heat exchanger.

One or more chips may be secured to the substrate. The one or more chips may be secured to an opposite side of the substrate to which the heat exchanger is in contact with. Put another way, the one or more chips may be secured to a first major surface of the substrate, and the heat exchanger may contact a second major surface of the substrate. The second major surface may be generally opposed to the first major surface.

The power module may be a power conversion module.

The first major surface of the heat exchanger may be in contact with a first major surface of the substrate.

It will be appreciated that the advantages discussed in relation to the first aspect of the invention apply to this aspect mutatis mutandis.

The power module may further comprise an inlet conduit that is connected to the inlet of the body of the heat exchanger, and an outlet conduit that is connected to the outlet of the body of the heat exchanger.

The cover may at least partially cover, or enclose, the inlet conduit and the outlet conduit.

The inlet conduit and the outlet conduit may be in direct sealing engagement with the body of the heat exchanger.

Where the inlet conduit and the outlet conduit are in direct sealing engagement with the body of the heat exchanger, the likelihood of a leak is reduced as compared to where a seal is provided between the inlet conduit or outlet conduit and the cover. Therefore, the inlet conduit and outlet conduit being in direct sealing engagement with the body advantageously reduces the likelihood of fluid leaking from the power module. Damage to the power module can occur as a result of fluid leakage. Therefore, the inlet conduit and outlet conduit being in direct sealing engagement with the body advantageously makes the power module more robust.

The inlet conduit may comprise an inlet connector and the outlet conduit comprises an outlet connector. The inlet connector and the outlet connector may be spaced apart from the body of the heat exchanger.

An inlet fluid line may be connectable to the inlet connector. An outlet fluid line may be connectable to the outlet connector.

Where an inlet connector and an outlet connector that are spaced apart from the body of the heat exchanger are provided, the likelihood of damage to the components of the power module is advantageously reduced. This is as compared to if the connectors adjoined the body of the heat exchanger. This is because, when installed into an inverter system housing, the inlet connector and the outlet connector can be disposed on an opposite side (i.e., outside of the housing) to the body of the heat exchanger. Therefore, any fluid that does leak at the interface between an inlet fluid line or an outlet fluid line and the inlet or outlet connector would not leak into the inverter system housing.

Where the inlet conduit and the outlet conduit are also in direct sealing engagement with the inlet and outlet of the body respectively, the likelihood of damage to the components of the power module is further reduced. This is because, with this arrangement, no seals are disposed within the inverter system housing when the power module is assemble into such a housing. As discussed above, seals present an opportunity for fluid leaks.

In a third aspect of the invention there is provided a method of manufacturing a heat exchanger for a power module. The method comprises forming at least one enclosed channel within a body such that the at least one enclosed channel is integrally formed with the body; and providing the body with an inlet and an outlet that are in fluid communication with the at least one enclosed channel.

The at least one enclosed channel may be formed within the body via friction stir channelling.

The method may further comprise brining an inlet conduit into direct sealing engagement with the inlet of the body and brining an outlet conduit into direct sealing engagement with the outlet conduit.

The inlet conduit may be brought into direct sealing engagement with the inlet of the body and the outlet conduit may be brought into direct sealing engagement with the outlet conduit via a solid state welding process.

The solid state welding process may be friction spin welding

The method may further comprise securing the body to a power module for an inverter system.

### Brief Description of the Drawings

Embodiments of the present invention will now be described with reference to the accompanying drawings, in which:
Figure 1 shows a perspective view of a power module in accordance with an embodiment of the present invention;
Figure 2 shows a cross-sectional view of the power module of Figure 1;
Figure 3 shows a top view of a heat exchanger of the power module of Figure 1;
Figure 4 shows the power module of Figure 1 positioned in a housing;
Figure 5 shows a perspective view of a power module according to another embodiment of the present invention; and
Figure 6 shows a top view of a heat exchanger of the power module of Figure 5.

### Detailed Description

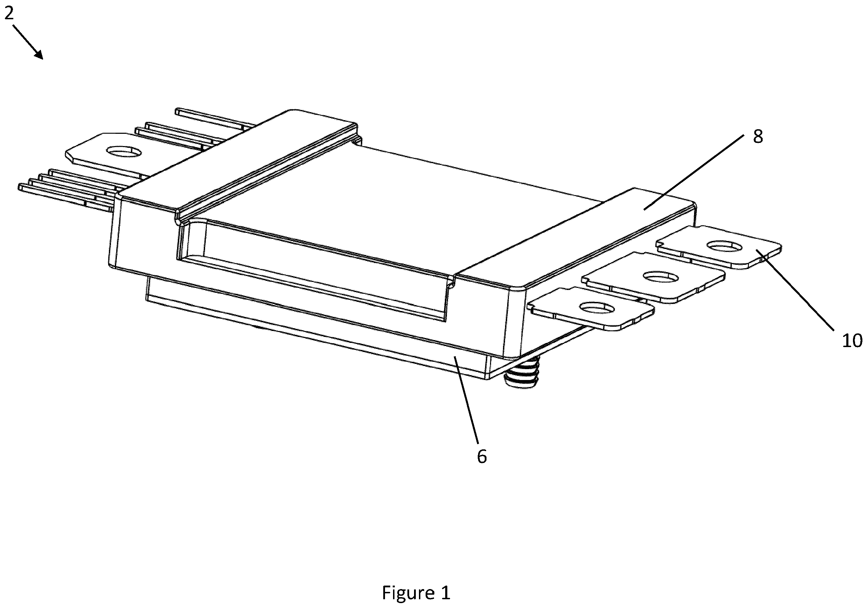

Figure 1 shows an power module 2 according to an embodiment of the present invention. The power module 2 comprises a substrate (not visible in Figure 1), a heat exchanger 6, and a cover 8. One or more chips (not shown in Figure 1 for clarity) are secured to the substrate. The cover 8 is a mould compound. The cover 8 at least partially covers the substrate and the heat exchanger 6. The phrase 'partially covers' means that not all sides are covered, but for example 5 of 6 sides are covered. Furthermore, the phrase may also mean that the entire surface of one of the sides may not be covered. The purpose of the cover 8 is to protect the other components of the power module 2 from environmental factors such as, for example, humidity and dust. The power module 2 is for use in an inverter system (not shown), preferably an inverter system for use in a vehicle (not shown), preferably an electric vehicle. The inverter system comprises a plurality of the power modules 2, preferably three or six of the power modules 2. The power module 2 comprises a plurality of connectors 10 (only one of which is labelled in Figure 1). The plurality of connectors 10 are for connecting the power module 2 to an external power supply (not shown) and to a component (not shown) which is to be powered by the power supply. The component may be an electric motor.

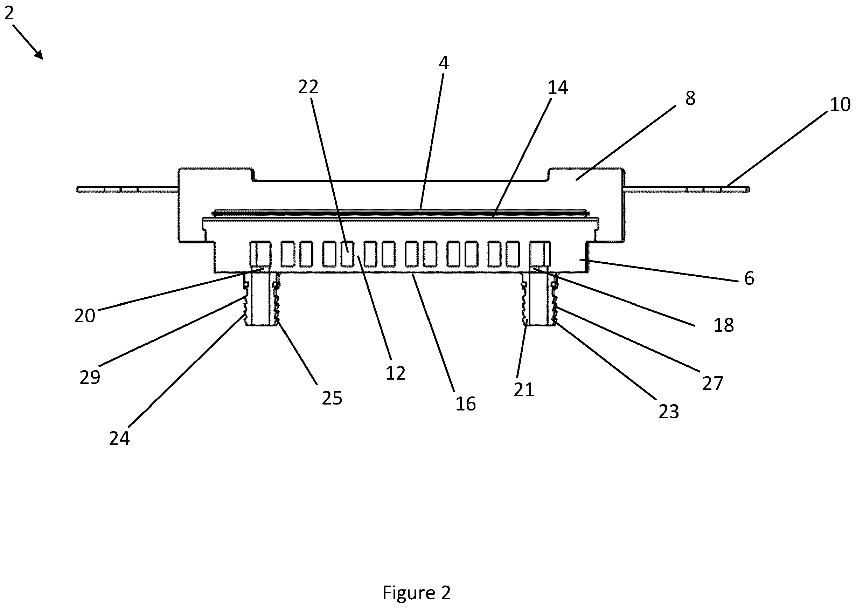

Figure 2 shows a cross-sectional view of the power module 2. The heat exchanger 6 comprises a body 12. The body 12 is generally plate-shaped. However, the body 12 can be any suitable shape, such as disc-shaped. The body 12 is formed of a laminated structure. The body 12 being formed of a laminated structure may be understood to mean that the body 12 is formed of multiple, separately formed, layers that are adhered, or otherwise adjoined, to one another. The body 12 comprises an aluminium layer, and a copper layer. The copper layer may adjoin, or be secured to, the substrate 4, and the aluminium layer may adjoin the copper layer. In some embodiments, the body 12 may comprise a plurality of copper layers between which an aluminium layer is sandwiched, or a plurality of aluminium layers between which a copper layer is sandwiched. The layers of the body 12 may be secured to one another via integral bonding. In some embodiments, the body 12 may be formed from a single layer of aluminium, or a single layer of copper. The body 12 comprises a first major surface 14, and a second major surface 16. The first major surface 14 is in contact with the substrate 4. The body 12 defines an inlet 18, and an outlet 20. A plurality of enclosed channels 22 are formed within the body 12. The plurality of enclosed channels 22 are in fluid communication with the inlet 18 and the outlet 20. The plurality of enclosed channels 22 are integrally formed within the body 12 of the heat exchanger 6. The plurality of enclosed channels 22 are, at least partially or fully, enclosed by the body 12 of the heat exchanger 6. The plurality of channels 22 being enclosed may be understood to mean that the channels are enclosed to define a flow area, but the channels 22 are able to receive a fluid from the inlet 18 and are able to discharge fluid from the body 12 via the outlet 20.

The heat exchanger 6 further comprises an inlet conduit 21 and an outlet conduit 24. The inlet conduit 21 is in direct sealing engagement with the inlet 18 of the body 12 of the heat exchanger 6 and configured to pass fluid into the plurality of enclosed channels 22 via the inlet conduit 21 and the inlet 18. The outlet conduit 24 is in direct sealing engagement with the outlet 20 of the body 12 of the heat exchanger 6 and configured to to be discharge fluid from the plurality of enclosed channels 22 via the outlet 20 and the outlet conduit 24. Throughout this application, the phrase 'direct sealing engagement' may be understood to mean that no separate sealing members are provided between the inlet conduit 21 and the inlet 18 or between the outlet conduit 24 and the outlet 20. In other words, the inlet conduit 21 and the outlet conduit 24 each extend from the inlet 18 and the outlet 20 of the body 12 respectively in a continuous manner.

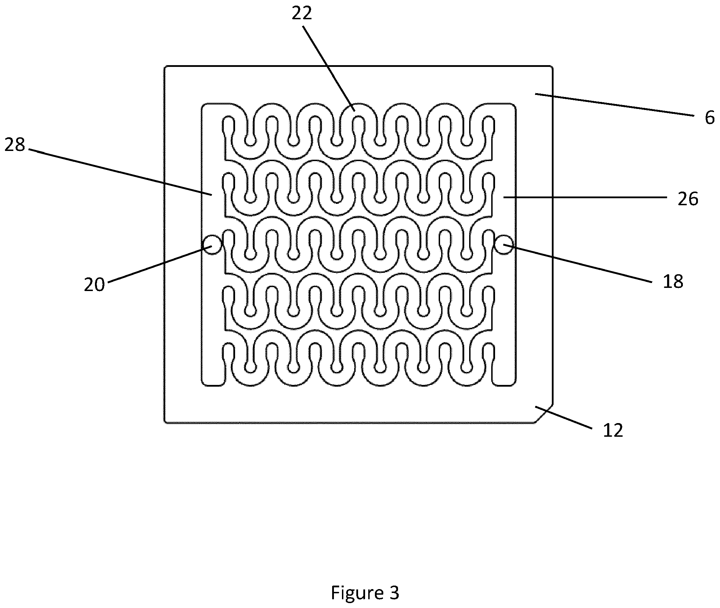

The inlet conduit 21 comprises an inlet connector 23. The outlet conduit 24 comprises an outlet connector 25. The inlet connector 23 and the outlet connector 25 each define a plurality of ribs 27, 29. An inlet fluid line (not shown in Figure 3) is connectable to the inlet connector 23, and an outlet fluid line (not shown in Figure 3) is connectable to the outlet connector 25. When connected to the inlet connector 23 or the outlet connector, the inlet fluid line and the outlet fluid line engages the respective plurality of ribs 27, 29, which increases the force required for the inlet fluid line to disconnect from the inlet connector 23. This reduces the likelihood of fluid leaking at the interface between the inlet or outlet fluid line and the inlet or outlet connector. In some, non-depicted, embodiments, the inlet connector and the outlet connector may take any other form suitable that allows for an inlet line and an outlet line respectively to engage the inlet conduit and the outlet conduit respectively. In some embodiments, the inlet conduit and the outlet conduit need not be provided.

Figure 3 shows a cross-sectional view of the heat exchanger 6. The cross-sectional view of Figure 3 is taken in a plane that is parallel to the first major surface (not visible in Figure 3) and the second major surface (not visible in Figure 3) of the body 12 of the heat exchanger 6. Each channel of the plurality of channels 22 extends between an inlet manifold 26 and an outlet manifold 28. Each channel of the plurality of channels 22 extends from the inlet manifold 26 to the outlet manifold 28. In some non-depicted, embodiments only a single enclosed channel that extends from the inlet 18 to the outlet 20 of the body 12 may be provided. Where a single channel is provided, the inlet manifold 26 and outlet manifold 28 need not be provided. Where a single channel is provided, it may comprise any of the features disclosed herein with respect to the plurality of channels 22. Each channel of the plurality of enclosed channels 22 defines a meandering path. In other words, each channel of the plurality of channels 22 defines a non-linear path. A non-linear path, compared to a linear path, increases the surface area of the edges (or sidewalls) of the enclosed channels 22. This improves the ability of the heat exchanger 6 to extract heat from the substrate (not shown in Figure 3). The width of each channel of the plurality of channels 22 may be constant along their respective length. That is to say, the width of each channel is constant between the inlet manifold 26 and the outlet manifold 28. The width of the channels refers to a minimum distance, measured in a plane that is parallel to the first major surface 14 of the body 12, between sidewalls of each channel. However, according to another embodiment to the invention, the width of each channel may be variable, and may be customised (or tailored) based on the configuration of the circuitry of the power module by, for example, having more, narrower (i.e., of a smaller spacing between the sidewalls of the channels) enclosed channels 22 in areas with circuitry which requires more heat dissipation capabilities, and having fewer, wider (i.e., of a larger spacing between the sidewalls of the channels) enclosed channels in areas where the circuitry has fewer elements which generate less heat.

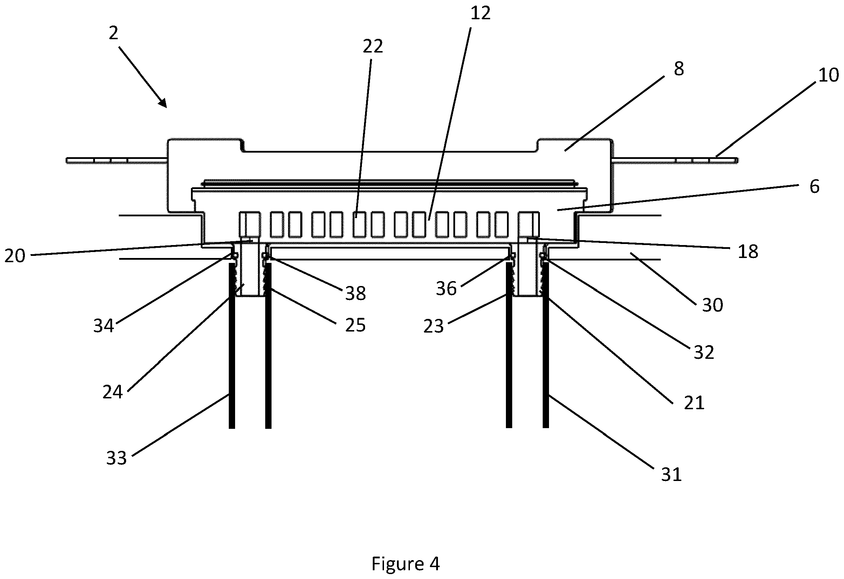

Figure 4 shows the power module 2 assembled into a housing 30. The housing 30 may be referred to as an inverter housing. Figure 4 also shows an inlet fluid line 31 connected to the inlet connector 23 and an outlet fluid line 33 connected to the outlet connector 25. The housing 30 serves to protect the power module 2 from, for example, impact, dust, and humidity during use. The housing 30 is hermetically sealed. The housing 30 comprises a first aperture 32 and a second aperture 34. The inlet conduit 21 extends through the first aperture 32. The outlet conduit 24 extends through the second aperture 34. A first seal member 36 is disposed between the inlet conduit 21 and the first aperture 32. The first seal member 36 seals against the inlet conduit 21 and the housing 30, in particular the first aperture 32. A second seal member 38 is disposed between the outlet conduit 24 and the second aperture 34. The second seal member 38 seals against the outlet conduit 23 and the housing 30, in particular the second aperture 34. The purpose of the first seal member 36 and the second seal member 38 is to prevent dust and/or moisture entering the housing 30. Therefore, the first and second seal members 36, 38 reduce the likelihood of damage to the power module 2 occurring during use.

As can be seen from Figure 4, the inlet connector 23 and the outlet connector 25 are disposed outside of the housing 30. This is desirable because if fluid leaks at one or both of the inlet connector 23 and the outlet connector 25, the likelihood of damage being caused to the power module 2 by the leaked fluid is reduced. This is as compared to if one or both of the connectors were disposed within the housing 30. In some embodiments, discussed below, the inlet connector 23 and the outlet connector 25 need not be disposed outside of the housing 30.

To manufacture the heat exchanger 6 a blank body 12 is provided. The body 12 being blank refers to an absence of the plurality of enclosed channels 22 within the body 12, and an absence of the inlet 18 and the outlet 20. Therefore, at this stage of manufacture of the heat exchanger, the body 12, or each layer of the body 12 where the body 12 is formed of a laminated structure, is continuous. Where the body 12 is not formed of a laminated structure, the blank body 12 may be provided as a solid block of material. The plurality of enclosed channels 22 are formed within the body 12. Friction stir channelling is then used to form the plurality of enclosed channels 22 within the body. In some embodiments, only a single channel is provided. Friction stir channelling is a process by which a probe, or tool, is rotated at high speeds whilst passing through a workpiece. An initial contact period is allowed to generate sufficient heat to soften the workpiece such that the probe can enter the workpiece. Movement of the probe through the workpiece results in the formation of an enclosed channel within the workpiece. To form an enclosed channel in the body 12 the tool may have a rotational speed of at least 400 rotations per second and/or up to 600 rotations per second. Additionally, the probe may have a translation speed of at least 25 mms per minute and/or up to 50 mms per minute. The use of friction stir channelling allows the plurality of enclosed channels 22 to be integrally formed with the body 12.

The plurality of enclosed channels 22 are preferably formed in the aluminium layer of the body 12 where the body 12 is formed from a laminated structure. As discussed above, where the body 12 is formed of a laminated structure, the laminated structure comprises an aluminium layer and a copper layer. It is preferable to form the plurality of channels in the aluminium layer because this reduces the risk of corrosion to the body 12 as compared to if the channels were formed in the copper layer. Once the plurality of enclosed channels 22 have been formed within the body 12, the inlet 18 and the outlet 20 are provided to the body 12. Once provided, the inlet 18 and the outlet 20 are in fluid communication with the plurality of enclosed channels 22. In some embodiments, the inlet 18 and outlet 20 may be provided to the body 12 prior to the plurality of channels 22 being provided to the body. The inlet 18 and the outlet 20 may be formed by, for example, milling.

Next, the inlet conduit 21 and the outlet conduit 24 are secured to the body 12 such that they are in direct sealing engagement with the inlet 18 and the outlet 20 respectively. The inlet conduit 21 and the outlet conduit 24 are secured to the body 12 via friction spin welding. Friction spin welding is a process in which one portion of a workpiece is held stationary whilst another portion of a workpiece is rotated at high speed. The portions are then brought into contact, generating friction. The friction that is generated between the two portions of the workpiece generates heat, which softens the workpieces. The workpieces are then moved towards one another, welding them together. Advantageously, the use of friction spin welding to connect the inlet conduit 21 and the outlet conduit 24 to the inlet 18 and the outlet 20 respectively removes the requirement for a separate sealing member to be provided at the interface between the inlet conduit 21 and the inlet 18 and the outlet conduit 24 and the outlet 20. In other embodiments, the inlet conduit 21 and the outlet conduit 24 may be connected to the inlet 18 and outlet 20 respectively via any other suitable method that allows direct sealing engagement between the inlet conduit 21 and the inlet 18 and between the outlet conduit 24 and the outlet 20. The inlet conduit 21 and the outlet conduit 24 may be connected to the inlet 18 and outlet 20 respectively via any suitable solid state welding process, such as ultrasonic welding. Alternatively, the inlet conduit may be connected to the inlet 18 and the outlet conduit 24 may be connected to the outlet 20 via a fusion welding process.

The heat exchanger 6 is then brought into contact with the substrate 4 such that the first major surface 14 of the body 12 of the heat exchanger 6 contacts the substrate 4. The body 12 may be secured to the substrate 4 via any suitable means, such as by using solder, sintering, and/or an adhesive. The body 12 is preferably secured to a copper layer of the body 12, but may be secured to an aluminium layer.

In other embodiments, the heat exchanger 6 may be manufactured via 3D printing.

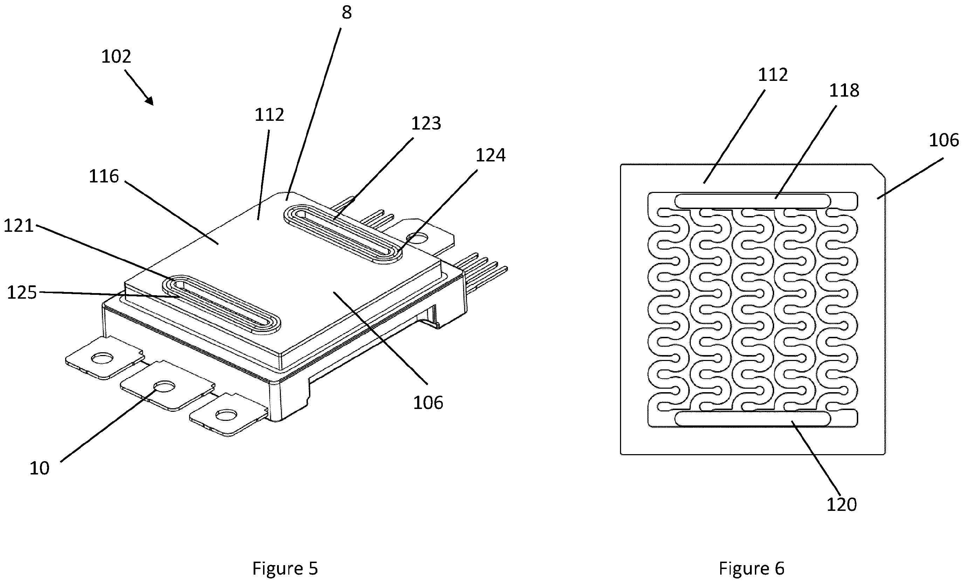

Figure 5 shows a further embodiment of a power module 102. In this embodiment, the inlet conduit 121 and the outlet conduct 124 are shorter than those of the previous embodiments. As a result, when the power module 102 is assembled into a housing (not shown in Figure 5), the inlet connector 123 and the outlet connector 125 are disposed within the housing. Since the inlet conduit 121 and the outlet conduit 124 are of a shorter length, the inlet connector 123 and the outlet connector 125 may be said to adjoin the body 112 of the heat exchanger 106. A reservoir (not depicted) is connectable to the inlet connector 123 and to the outlet connector 125 such that the reservoir is in fluid communication with the plurality of channels (not visible in Figure 5).

Figure 6 shows a cross-sectional view of the heat exchanger 106 of the power module 102. The cross-section of Figure 6 is taken in a plane that is parallel to the second major surface (not visible in Figure 6, it is out of the plane of view). In this embodiment, the inlet 118 and the outlet 120 of the body 112 are stadium shaped. However, the inlet 118 and the outlet 120 may be any suitable shape, such as circular. The features of the heat exchanger 106 are the same as the features of the heat exchanger 6 except as identified herein. The heat exchanger 106 may comprise any of the features discussed above in relation to the heat exchanger 6. The heat exchanger 106 is advantageously more efficient to manufacture than the heat exchanger 6.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A heat exchanger for a power module for an inverter system, the heat exchanger comprising:
a body that defines an inlet, an outlet;
wherein at least one enclosed channel is integrally formed within the body, the at least one enclosed channel being in fluid communication with the inlet and the outlet.

2. The heat exchanger of claim 1 or claim 2, wherein the at least one channel defines a meandering path.

3. The heat exchanger of claim 1 or claim 2, wherein a width of the at least one channel is constant along a length of the at least one channel.

4. The heat exchanger of any preceding claim, wherein a plurality of enclosed channels, an inlet manifold and an outlet manifold are formed within the body, and wherein each of the channels of the plurality of channels extend between the inlet manifold and the outlet manifold.

5. The heat exchanger of any preceding claim, further comprising an inlet conduit that is in direct sealing engagement with the inlet and an outlet conduit that is in direct sealing engagement with the outlet.

6. A power module for an inverter system, the power module comprising:
a substrate;
a heat exchanger according to any of claims 1 to 4, a first major surface of the body of the heat exchanger being in contact with the substrate; and
a cover that at least partially covers the substrate, and the heat exchanger.

7. The power module of claim 6, further comprising an inlet conduit that is connected to the inlet of the body of the heat exchanger, and an outlet conduit that is connected to the outlet of the body of the heat exchanger.

8. The power module of claim 7, wherein the inlet conduit and the outlet conduit are in direct sealing engagement with the body of the heat exchanger.

9. The power module of claim 7 or claim 8, wherein the inlet conduit comprises an inlet connector and the outlet conduit comprises an outlet connector, and wherein the inlet connector and the outlet connector are spaced apart from the body of the heat exchanger.

10. A method of manufacturing a heat exchanger for a power module, the method comprising:
forming at least one enclosed channel within a body such that the at least one enclosed channel is integrally formed with the body;
providing the body with an inlet and an outlet that are in fluid communication with the at least one enclosed channel.

11. The method of claim 10, wherein the at least one enclosed channel is formed within the body via friction stir channelling.

12. The method of claim 10 or claim 11, further comprising brining an inlet conduit into direct sealing engagement with the inlet of the body and brining an outlet conduit into direct sealing engagement with the outlet conduit.

13. The method of claim 12, wherein the inlet conduit is brought into direct sealing engagement with the inlet of the body and the outlet conduit is brought into direct sealing engagement with the outlet conduit via a solid state welding process.

14. The method of claim 13, wherein the solid state welding process is friction spin welding

15. The method of any of claims 10 to 14, further comprising securing the body to a power module for an inverter system.
